# EUROPÄISCHE PATENTSCHRIFT

(11) **EP 1 205 350 B1**
(45) Veröffentlichungstag und Bekanntmachung des Hinweises auf die Patenterteilung: **01.10.2008**
(21) Anmeldenummer: 01120601.8
(22) Anmeldetag: 29.08.2001
(51) Int. Cl.: B60Q 1/14

(54) **Lenkstockschalter, insbesondere für Fahrzeuge**
Steering column switch
Interrupteur de colonne de direction

(30) Priorität: 10.11.2000 DE 10056665
(43) Veröffentlichungstag der Anmeldung: 15.05.2002
(73) Patentinhaber: Valeo Schalter und Sensoren GmbH, 74321 Bietigheim-Bissingen (DE)
(72) Erfinder: Hecht, Walter, 74321 Bietigheim-Bissingen (DE); Simonis, Karl, 75428 Illingen (DE); Klein, Rudolf, 74348 Lauffen a.N. (DE)
(74) Vertreter: Dreiss, Fuhlendorf, Steimle & Becker

(56) Entgegenhaltungen:
- EP-A- 0 763 447
- EP-A- 0 861 753
- DE-A1- 4 204 372
- DE-A1- 19 801 526
- US-A- 5 602 427
- US-A- 5 952 633

## Beschreibung

Die Erfindung betrifft einen Lenkstockschalter, insbesondere für Kraftfahrzeuge mit einem Grundgehäuse mit Boden- und Seitenwänden, mit einem Gehäusedeckel, mit mehreren Schaltereinheiten und mit die Schaltereinheiten kontaktierenden Leiterbahnen.

Derartige Lenkstockschalter finden insbesondere im Kraftfahrzeugbau Verwendung. Sie weisen üblicherweise einen zentralen Durchbruch auf, in welchem in montiertem Zustand die Lenksäule des Kraftfahrzeuges angeordnet ist. Weiterhin sehen die Lenkstockschalter verschiedene Betätigungshebel vor, über welche die das Kraftfahrzeug bedienende Person Schaltfunktionen ausführen kann. Derartige Schaltfunktionen werden über separat an dem Lenkstockschalter angeordnete oder auch in den Lenkstockschalter integrierte Schaltereinheiten ausgeführt. Die Schaltereinheiten dienen dabei bspw. zum Ein- und Ausschalten einer Kraftfahrzeugbeleuchtung, zum Schalten von Fahrzeugblinkern, von Scheibenwischvorrichtungen, von einer Fahrzeughupe, von einem Multifunktionsdisplay, von einem Fahrzeugtempomat oder dergleichen. Zum Betätigen der Schaltereinheiten weist der Lenkstockschalter üblicherweise mehrere Betätigungshebel auf. Zur elektrischen Versorgung der Schalteinheiten ist es erforderlich, elektrische Leiterbahnen im Lenkstockschalter vorzusehen. Diese Leiterbahnen werden üblicherweise als Kabelstränge in bzw. durch den Lenkstockschalter geführt. Dies hat allerdings den Nachteil, dass insbesondere bei Vorhandensein mehrerer Schaltereinheiten die Kabelführung sehr umständlich ist und viel Bauraum beansprucht. Dies ist insbesondere dann problematisch, wenn bspw. eine Schaltereinheit auf der einen Seite des Lenkstockschalters angeordnet ist und mit einem auf der anderen Seite des Lenkstockschalters vorhandenen Steckerkontakt mit bspw. einer zentralen Steuereinheit verbunden werden soll.

Aus der DE 38 02 462 A1 ist ein Lenkstockschalter bekannt geworden, der ein Gehäuse mit einem Boden und Seitenwände offenbart. Ein Deckel schließt dabei das Innere des Schalters nach oben ab. In der Grundplatte und in den Seitenwänden ist eine Blechplatine durch Umspritzen eingebettet, aus der mehrere Leiterbahnen ausgestanzt sind und die vor dem Umspritzen eine U-förmige Gestalt erhalten hat.

Aus der DE 691 17 687 T2 (EP 0 489 654 B1) ist eine Schalteranordnung mit einem Gehäuse bekannt geworden, das zwei Schalen aufweist. Eine der Schalen umfasst eine Platte, an der insbesondere ein Kontaktblock für ein Schloss, Schmelzsicherungen und ein Steckerabgang vorgesehen ist.

Aus der US 5,952,633 (DE 197 56 820 A1) ist ein Lenksäulen-Hebelschalter bekannt geworden, bei dem auf einem Einsatz Schaltereinheiten kontaktierende Leiterbahnen angeordnet sind.

Der vorliegenden Erfindung liegt die Aufgabe zugrunde, einen Lenkstockschalter bereitzustellen, der trotz Vorhandensein mehrerer Schaltereinheiten auf einfache Art und Weise montierbar und insbesondere kontaktierbar ist.

Diese Aufgabe wird bei einem Lenkstockschalter mit den Merkmalen des Anspruchs 1 gelöst. Über ein Kontaktgitter, das nicht nur in einer Ebene ausgebildet ist, entfallen innerhalb des Lenkstockschalters vorhandene Kabelstränge, die bspw. eine Schaltereinheit des Lenkstockschalters mit einem zugehörigen, an einer anderen Stelle des Lenkstockschalters vorhandenen Steckerkontakten verbindet.

Ein weiterer Vorteil der Erfindung ist, dass insbesondere auch der üblicherweise an dem Lenkstockschalter zentral vorhandene Durchbruch kein Hindernis für die Leiterbahnen bzw. für das Kontaktgitter darstellt, da dieses in diesem zentralen Bereich bspw. über Abschnitte der Seitenwände des Grundgehäuses verlaufen kann.

Weiterhin vorteilhaft ist, dass der Gehäusedeckel wenigstens abschnittsweise die Außenseite wenigstens einer Seitenwand des Grundgehäuses abdeckt. Dies hat insbesondere den Vorteil, dass Leiterbahnen nicht unbedingt innerhalb des Lenkstockschalters, sondern auch bspw. auf der Außenfläche einer Seitenwand verlaufen können. Durch Abdecken der Bereiche, in welchen die Leiterbahnen auf der Außenseite des Grundgehäuses des Lenkstockschalters verlaufen, werden diese von dem Gehäusedeckel geschützt. Hierdurch wird insbesondere eine flexiblere Ausgestaltung des gesamten Lenkstockschalters möglich.

Besonders vorteilhaft ist, wenn wenigstens eine Schaltereinheit ganz oder teilweise auf der Außenseite des Grundgehäuses an dem Grundgehäuse des Lenkstockschalters angeordnet ist. Bei einem derartigen Lenkstockschalter wird insbesondere Bauraum innerhalb des Grundgehäuses eingespart, wodurch der gesamte Lenkstockschalter kleiner ausführbar ist. Außerdem kann durch Anbringen von Schaltereinheiten bzw. deren Teile auf der Außenseite des Grundgehäuses der Montagevorgang des gesamten Lenkstockschalters wesentlich vereinfacht werden. Eine Montage von der Außenseite kann entlang einer geradlinigen Achse erfolgen. Hierdurch können insbesondere in der Großserienfertigung enorme Kosten eingespart werden.

Eine besonderes vorteilhafte Ausgestaltung der Erfindung sieht vor, dass der Gehäusedeckel wenigstens abschnittsweise die Außenseiten des Grundgehäuses abdeckt, an welchen bspw. Schaltereinheiten ganz oder teilweise angeordnet sind. Hierdurch werden auf der Außenseite des Grundgehäuses angeordnete Schaltereinheiten bzw. deren Teile nach deren Montage von dem Gehäusedeckel schützend abgedeckt.

Erfindungsgemäß kann vorteilhafterweise ebenso vorgesehen sein, dass das Kontaktgitter freie Kontaktenden in Form von Steckerlitzen aufweist. Hierdurch entfallen zusätzliche Bauteile, die zur Kontaktierung von Steckerelementen an die Leiterbahnen anzuordnen wären. Als besonders vorteilhaft hat sich ein Kontaktgitter herausgestellt, dass über Abschnitte des Bodens des Grundgehäuses als auch über Abschnitte der Seitenwände des Grundgehäuses verläuft und sämtliche Steckerlitzen in einem Bereich bzw. auf einer Seite des Lenkstockschalters aufweist. Dies hat den Vorteil, dass sämtliche mit dem Lenkstockschalter zu kontaktierenden Kabelstränge auf lediglich einer Seite des Lenkstockschalters auf die Steckerlitzen aufzustecken sind. Dabei ist auch denkbar, dass lediglich ein Stecker vorgesehen werden kann, der sämtliche Steckerlitzen umfasst. Damit ist zur Kontaktierung des Lenkstockschalters mit bspw. einer zentralen Steuereinheit lediglich ein Steckerelement mit dem Lenkstockschalter bzw. mit den freien Kontaktenden in Form von Steckerlitzen zu verbinden.

Um denkbare Kurzschlüsse aufgrund von in den Lenkstockschalter eindringenden Metallteilen zu vermeiden, kann erfindungsgemäß vorgesehen sein, dass das Kontaktgitter wenigstens abschnittsweise in das Grundgehäuse eingeformt ist.

Eine weitere Ausführungsform der Erfindung sieht vor, dass wenigstens eine Seitenwand des Grundgehäuses Freiformstellen im Bereich des Kontaktgitters aufweist. Derartige Freiformstellen können insbesondere aufgrund eines Einformens des Kontaktgitters entstehen. Besonders vorteilhaft können derartige Freiformstellen mit einem Gehäusedeckel schützend abgedeckt werden.

Ebenso ist denkbar, dass nach dem Einformen des Kontaktgitters in das Grundgehäuse das Kontaktgitter an vorhergesehenen Stellen abgetrennt wird. Dies hat den Vorteil, dass das Kontaktgitter als einstückiges, zusammenhängendes Gitter eingeformt werden kann. Unerwünschte Kontaktstellen werden dann zu einem späteren Zeitpunkt abgetrennt, so dass getrennte Leiterbahnen entstehen. Vorteilhafterweise können derartige Abtrennstellen von dem Gehäusedeckel schützend abgedeckt werden.

Eine weitere, ebenfalls bevorzugte Ausführungsform der Erfindung sieht vor, dass auf der Innenseite des Grundgehäuses im Bereich des Kontaktgitters zugängliche Kontaktstellen vorhanden sind, die von einem eine Kontaktbrücke aufweisenden Kontaktschlitten überfahren werden. Vorteilhafterweise ist das Kontaktgitter hierbei unmittelbar Bestandteil einer in den Lenkstockschalter integrierten Schalteinheit. Damit entfallen zusätzliche Bauteile, wie bspw. eine Schalterplatine, die derartige Kontaktstellen vorsieht. Ein derartiger Lenkstockschalter weist also insgesamt eine geringere Anzahl von Bauteilen auf und kann daher sehr kompakt ausgeführt werden.

Weitere vorteilhafte Ausgestaltungen und Einzelheiten der Erfindung sind der nachfolgenden Beschreibung zu entnehmen, an der die Erfindung anhand des in der Zeichnung dargestellten Ausführungsbeispiels näher beschrieben und erläutert ist.

Es zeigen:
- Figur 1: einen erfindungsgemäßen Lenkstockschalter in perspektivischer Draufsicht,
- Figur 2: den Lenkstockschalter gemäß Figur 1 in perspektivischer Ansicht von schräg unten,
- Figur 3: ein mehrteiliges Kontaktgitter des erfindungsgemäßen Lenkstockschalters gemäß Figur 1 bis 3,
- Figur 4: das Grundgehäuse des Lenkstockschalters gemäß Figur 1 und 2,
- Figur 5: einen Querschnitt durch den erfindungsgemäßen Lenkstockschalter gemäß Figur 1 und 2 ohne Schaltereinheiten,
- Figur 6: das Grundgehäuse des Lenkstockschalters gemäß Figur 1 bis 5 in perspektivischer Ansicht mit verschiedenen Schaltereinheiten und
- Figur 7: einen Ausschnitt des Lenkstockschalters gemäß Figuren 1 - 6.

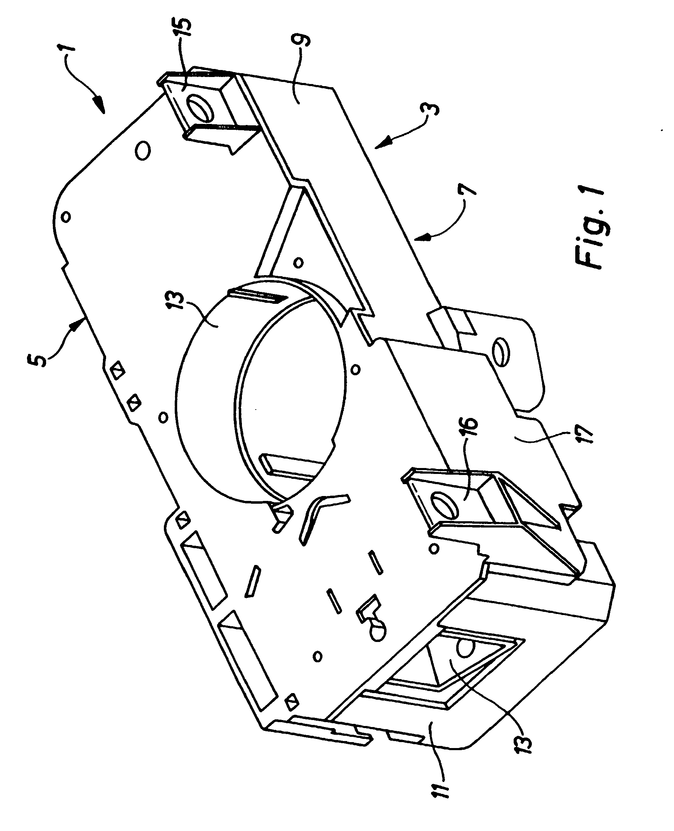

Der in der Figur 1 dargestellte Lenkstockschalter 1 weist ein Grundgehäuse 3 und ein auf das Grundgehäuse 3 aufgesetzten Gehäusedeckel 5 auf. Das Grundgehäuse umfasst einen Boden 7 sowie zwei Seitenwände 9 an den Längsseiten und zwei Seitenwände 11 an den Querseiten. Der Lenstockschalter 1 weist in seinem zentralen Bereich einen weitgehend zylinderförmigen Durchbruch 13 auf, in welchem in montiertem Zustand die Lenksäule eines Kraftfahrzeuges angeordnet ist. An seiner Oberseite weist der Gehäusedeckel 5 zwei Befestigungsabschnitte 15 und 16 auf, über welche weitere Bauteile, wie bspw. ein Lenkwinkelsensor, mit dem Lenkstockschalter 1 verbunden werden können.

Aus Fig. 1 geht deutlich hervor, dass der die Seitenwand 9 abdeckende Abschnitt 17 des Gehäusedeckels 5 sich nahezu über die Hälfte der in Fig. 1 zu sehenden Seitenwand 9 erstreckt.

An den Querseitenwänden 11 sieht das Grundgehäuse 3 jeweils eine Aussparung 19 vor. Durch die Aussparung 19 ragt in vollständig montiertem Zustand des Lenkstockschalters 1 jeweils ein Schalthebel, über den der Lenkstockschalter 1 betätigbar ist.

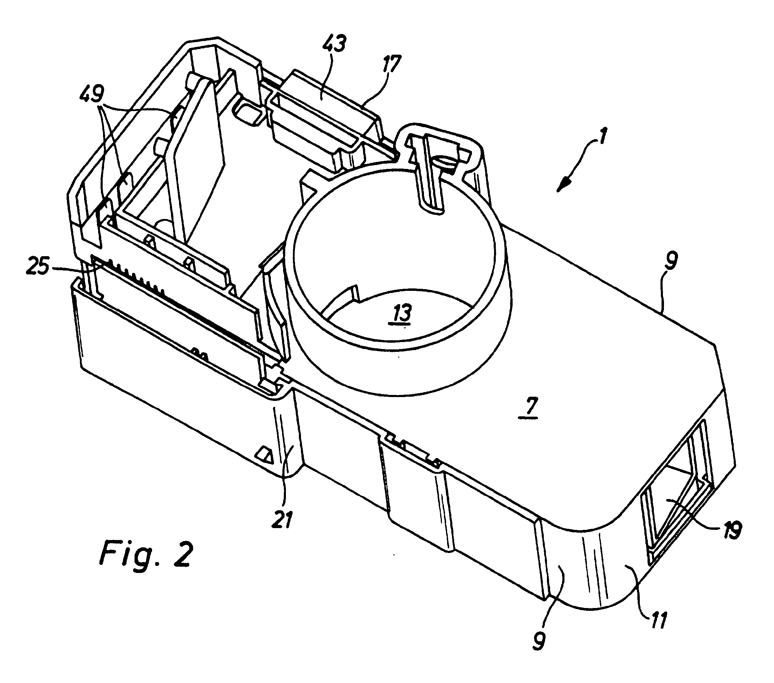

Fig. 2 zeigt die Unterseite des Lenkstockschalters 1 sowie die in Fig. 1 nicht zu sehende Rückseite. Deutlich zu erkennen ist, dass die in Fig. 1 nicht zu sehende Seitenwand 9 nahezu vollständig von einem Abschnitt 21 des Gehäusedeckels 5 abgedeckt wird.

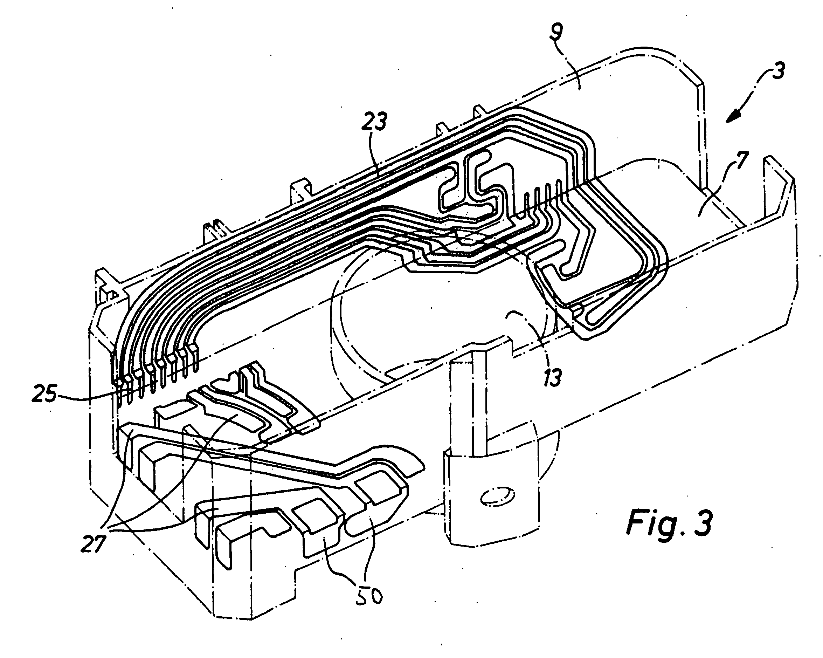

Fig. 3 zeigt das Grundgehäuse 3 in angedeuteter Weise, in welchem Leiterbahnen in Form von einem mehrteiligen Kontaktgitter 23 verlaufen. Dabei ist zu erkennen, dass das Kontaktgitter 23 sich über Abschnitte des Bodens 7 des Grundgehäuses 3 als auch über Abschnitte der einen Seitenwand 9 erstreckt. Vorteilhafterweise ist das Kontaktgitter 23 in das Grundgehäuse 3 eingeformt.

Über den in der Seitenwand 9 verlaufenden Abschnitt des Kontaktgitters 23 können freie Kontaktenden in Form von Steckerlitzen 25, die in Fig. 3 links von dem zentralen Durchbruch 13 angeordnet sind, mit Schaltereinheiten elektrisch verbunden werden, die in Fig. 3 rechts von dem zentralen Durchbruch 13 angeordnet werden können. Vorteilhafterweise können hierdurch sämtliche in dem Grundgehäuse 5 anzuordnenden Schaltereinheiten auf der gleichen Seite des Lenkstockschalters 1 bzw. des Grundgehäuses 3 abgegriffen werden. Neben dem Kontaktgitter 23 ist in dem Grundgehäuse 3 noch ein weiteres Kontaktgitter 27 angeordnet, welches lediglich im Boden 7 des Gehäusedeckels 5 verläuft. Dieses Kontaktgitter 27 ist zur elektrischen Kontaktierung von Schaltereinheiten vorgesehen, die in Fig. 3 links von dem zentralen Durchbruch angeordnet sind.

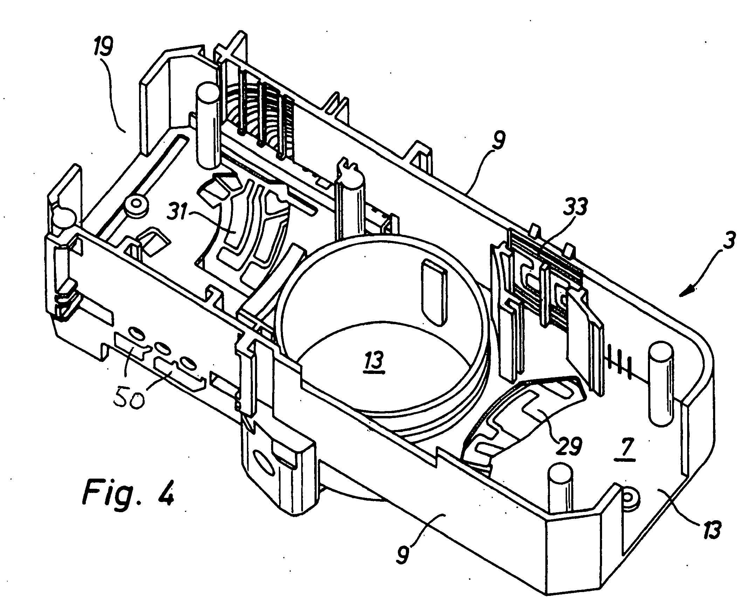

Fig. 4 zeigt eine ähnliche Ansicht des Grundgehäuses 3 wie Fig. 3. Allerdings ist das Grundgehäuse 3 in Fig. 4 vollständig dargestellt, so dass das Gitter 23 und 27 lediglich an den freigelegten Stellen sichtbar sind. Die in dem Boden 27 des Grundgehäuses 3 freigelegten Stellen 29 und 31 des Kontaktgitters 23 bzw. 27 werden im vollständig montierten Zustand des Lenkstockschalters 1 von nicht dargestellten Kontaktbrücken überfahren. Je nach Stellung der Kontaktbrücken ergibt sich eine vorgesehene Schaltstellung. Eine weitere freigelegte Stelle 33 des Kontaktgitters 23 ist an der Innenseite des Grundgehäuses 3 vorhanden. Auf diese freigelegte Stelle 33 wird in vollständig montiertem Zustand von einem eine Kontaktbrücke aufweisenden Kontaktschlitten überfahren.

Die Kontrastbrücken bzw. die die Kontrastbrücken aufweisenden Kontaktschlitten werden hierbei direkt oder mittelbar von den in dem Lenkstockschalter 1 liegenden Enden der durch die Aussparungen 19 ragenden Schalthebel betätigt.

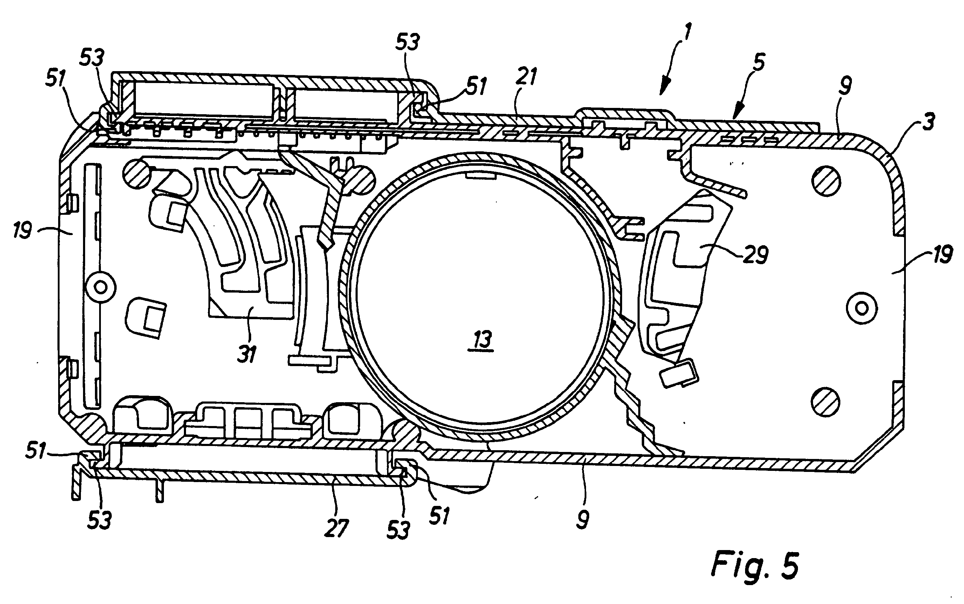

Der in Fig. 5 dargestellte Querschnitt durch das Grundgehäuse 3 und den Gehäusedeckel 5 zeigt deutlich, dass der Gehäusedeckel 5 mit seinen Abschnitten 17 und 21 das Grundgehäuse im Bereich der Seitenwände 9 abdeckt. Deutlich zu erkennen sind auch die beiden freigelegten Stellen 29 und 31. In Fig. 5 sind keine Bauteile der in oder an dem Lenkstockschalter 1 angeordenbaren Schaltereinheiten dargestellt.

Wie insbesondere aus Fig. 5 deutlich hervorgeht, weist der Gehäusedeckel den Grundkörper 3 umgreifende Abschnitte 51 auf. Bei der Montage des Gehäusedeckels 5 mit dem Grundkörper 3 wird der Gehäusedeckel 5 axial zur Längsachse des Durchbruchs 13 auf den Grundkörper 3 aufgeschoben. Hierbei gelangen die umgreifenden Abschnitte 51 des Gehäusedeckels 5 in an dem Grundgehäuse angeordnete Führungsstege 53.

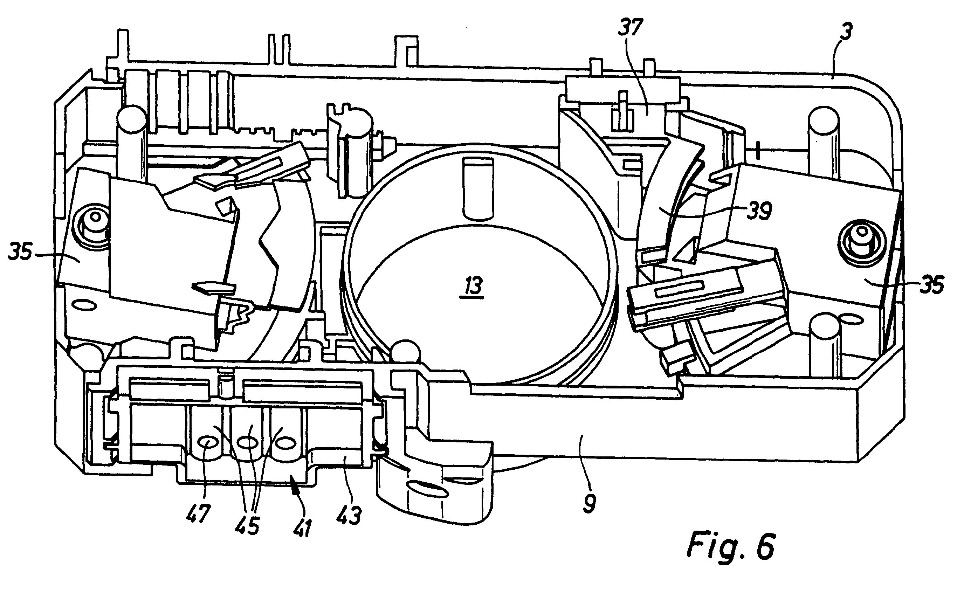

Figur 6 zeigt das Grundgehäuse 3 mit darin angeordneten Mitnehmerelementen 35, welche zur Aufnahme der an dem Lenkstockschalter 1 anordenbaren Schalthebel dienen. An den den Kontaktstellen 29 und 31 zugewandten Seiten der Mitnehmerelemente 35 sind nicht zu sehende Kontaktschlitten mit entsprechenden Kontaktbrücken vorgesehen.

Im Bereich der Kontaktstelle 33 ist in Fig. 6 ein Kontaktschlitten 37 dargestellt. Der Kontaktschlitten 37 weist auf seiner dem Mitnehmerelement 35 zugewandten Seite einen Mitnahmesteg 39 auf, über den der Kontaktschlitten 37 von dem Mitnehmerelement 35 betätigt werden kann.

Fig. 6 sieht weiterhin eine Schaltereinheit 41 vor, die eine Kunststofffassung 43 mit drei darin angeordneten Federzungen 45 umfasst. An den Federzungen ist jeweils ein beweglicher Kontakt 47 angeordnet, die über eine nicht dargestellte Steuerkurve mit entsprechend vorhandenen Festkontakten 50 in Kontakt gebracht werden können. Zur Montage der Schaltereinheit 41 kann die Kunststofffassung 43 entlang einer geradlinigen Montagerichtung von der Gehäuseaußenseite an das Grundgehäuse 3 angesetzt werden.

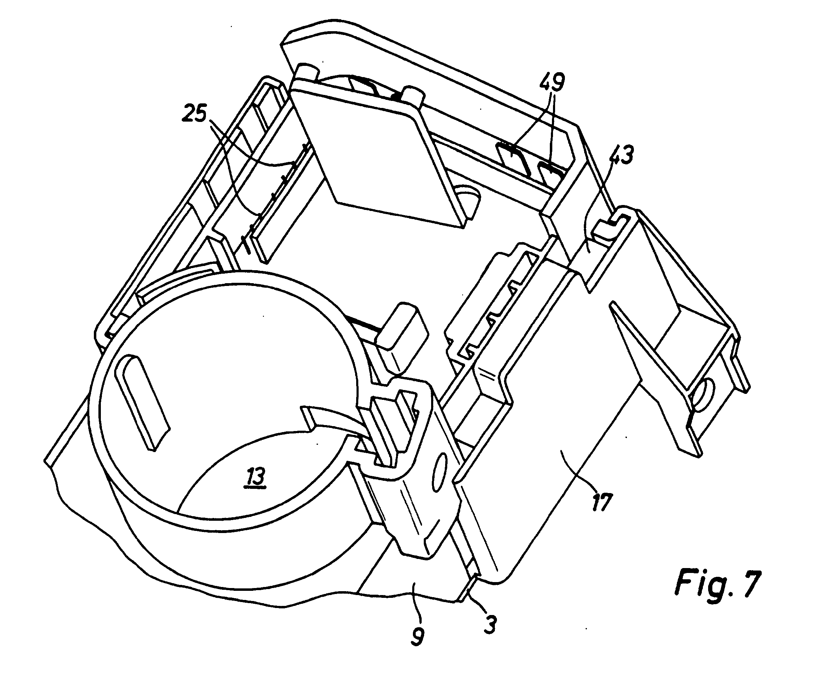

Wie aus Fig. 7 deutlich wird, deckt der Abschnitt 17 des Gehäusedeckels 3 die Kunststofffassung 43 samt Federzungen 45 in montiertem Zustand ab. In Fig. 7 sind außerdem die Steckerlitzen 25 des Kontaktgitters 23 zu erkennen. Ebenso sind freie Enden 49 des anderen Kontaktgitters 27 zu sehen.

Besondere Vorteile des Lenktstockschalters 1 gemäß den im Vorhergehenden beschriebenen Figuren ist, dass zum einen sämtliche Steckerkontakte 25 und 49 auf der gleichen Seite des Lenkstockschalters 1 angeordnet sind. Dies wird insbesondere dadurch erreicht, dass sich das Kontaktgitter 23 über den Boden 7 als auch über die eine Seitenwand 9 des Grundgehäuses 3 erstreckt. Weiterhin ist besonders vorteilhaft, dass der Gehäusedeckels 5 Abschnitte der Seitenwände 9 des Grundgehäuses 3 abdeckt. Hierdurch können insbesondere in den Figuren nicht dargestellte Freiformstellen abgedeckt werden, die beim Umformen bzw. beim Einformen der Kontaktgitter 23 und 27 entstehen. Weiterhin können vorteilhafterweise ganz oder teilweise an der Außenseite des Grundgehäuses 3 angeordnete Schaltereinheiten 41 abgedeckt werden.

Alle in der Beschreibung, den nachfolgenden Ansprüchen und der Zeichnung dargestellten Merkmale können sowohl einzeln als auch in beliebiger Kombination miteinander erfindungswesentlich sein.

## Patentansprüche

1. Lenkstockschalter (1), insbesondere für Kraftfahrzeuge, mit einem Grundgehäuse (3) mit Boden (7) und Seitenwänden (9, 11), mit einem Gehäusedeckel (5), mit mehreren Schaltereinheiten (35, 41) und mit die Schaltereinheiten (35, 41) kontaktierenden Leiterbahnen, wobei die Leiterbahnen als ein ein- oder mehrteiliges in das Grundgehäuse (3) wenigstens abschnittsweise eingeformtes Kontaktgitter (23, 27) ausgebildet sind und wobei sich das Kontaktgitter (23) über Abschnitte wenigstens einer Seitenwand (9) und des Bodens (7) des Grundgehäuses (3) erstreckt, **dadurch gekennzeichnet, dass** Kontakte (50) des Kontaktgitters (23, 27) auf der Außenseite einer Seitenwand (9, 11) des Grundgehäuses (3) zur Kontaktierung einer wenigstens teilweise auf der Außenseite des Grundgehäuses (3) angeordneten Schaltereinheit (41) zugänglich angeordnet sind, wobei der Gehäusedeckel (5) die die wenigstens teilweise auf der Außenseite des Grundgehäuses (3) angeordnete Schaltereinheit (41) wenigstens teilweise abdeckt.

2. Lenkstockschalter (1) nach Anspruch 1, **dadurch gekennzeichnet, dass** das Kontaktgitter (23) freie Kontaktenden in Form von Steckerlitzen aufweist.

3. Lenkstockschalter (1) nach einem der vorhergehenden Ansprüche, **dadurch gekennzeichnet, dass** wenigstens eine Seitenwand (9, 11) Freiformstellen im Bereich des Kontaktgitters (23) aufweist.

4. Lenkstockschalter (1) nach einem der vorhergehenden Ansprüche, **dadurch gekennzeichnet, dass** wenigstens eine Seitenwand (9) Abtrennstellen des Kontaktgitters (23) aufweist.

5. Lenkstockschalter (1) nach einem der vorhergehenden Ansprüche, **dadurch gekennzeichnet, dass** auf der Innenseite des Grundgehäuses (5) im Bereich des Kontaktgitters (23) zugängliche Kontaktstellen (29, 31, 33) vorhanden sind, die von einem eine Kontaktbrücke aufweisenden Kontaktschlitten (37, 39) überfahren werden.

## Claims

1. Steering column switch (1), in particular for motor vehicles, comprising the basic housing (3) having a bottom (7) and side walls (9, 11), comprising a housing cover (5), comprising a plurality of switch units (35, 41) and comprising conductor tracks making contact with the switch units (35, 41), the conductor tracks being in the form of a one-part or multipart contact grid (23, 27) moulded at least in sections in the basic housing (3), and the contact grid (23) extending over sections of at least one side wall (9) and of the bottom (7) of the basic housing (3), **characterized in that** contacts (50) of the contact grid (23, 27) are arranged accessibly on the outside of a side wall (9, 11) of the basic housing (3) for making contact with a switch unit (41) arranged at least partly on the outside of the basic housing (3), the housing cover (5) at least partly covering the switch unit (41) arranged at least partly on the outside of the basic housing (3).

2. Steering column switch (1) according to Claim 1, **characterized in that** the contact grid (23) has free contact ends in the form of plug wires.

3. Steering column switch (1) according to either of the preceding claims, **characterized in that** at least one side wall (9, 11) has free-form surfaces in the region of the contact grid (23).

4. Steering column switch (1) according to any of the preceding claims, **characterized in that** at least one side wall (9) has isolating points of the contact grid (23).

5. Steering column switch (1) according to any of the preceding claims, **characterized in that** contact points (29, 31, 33) which are accessible on the inside of the basic housing (5) in the region of the contact grid (23) and over which a contact carriage (37, 39) having a contact bridge travels are present.

## Revendications

1. Commutateur de colonne de direction (1), en particulier pour véhicules automobiles, avec un boîtier de base (3) comprenant un fond (7) et des parois latérales (9, 11), avec un couvercle de boîtier (5), avec plusieurs unités de commutateurs (35, 41) et avec des pistes conductives établissant un contact avec les unités de commutateurs (35, 41), dans lequel les pistes conductives sont réalisées comme un réseau de contact (23, 27) en une ou plusieurs parties, intégré au moins par endroits dans le boîtier de base (3), et dans lequel le réseau de contact (23) s'étend sur des sections au moins d'une paroi latérale (9) et du fond (7) du boîtier de base (3), **caractérisé en ce que** des contacts (50) du réseau de contact (23, 27) sont disposés sur le côté extérieur d'une paroi latérale (9, 11) du boîtier de base (3) pour établir le contact avec une unité de commutateurs (41) disposée de façon accessible au moins en partie sur le côté extérieur du boîtier de base (3), dans lequel le couvercle de boîtier (5) recouvre au moins en partie l'unité de commutateurs (41) disposée au moins en partie sur le côté extérieur du boîtier de base (3).

2. Commutateur de colonne de direction (1) selon la revendication 1, **caractérisé en ce que** le réseau de contact (23) présente des extrémités de contact libres sous forme de fils torsadés de connecteur.

3. Commutateur de colonne de direction (1) selon l'une quelconque des revendications précédentes, **caractérisé en ce qu'**au moins une paroi latérale (9, 11) présente des endroits de forme libre au niveau du réseau de contact (23).

4. Commutateur de colonne de direction (1) selon l'une quelconque des revendications précédentes, **caractérisé en ce qu'**au moins une paroi latérale (9) présente des points de séparation du réseau de contact (23).

5. Commutateur de colonne de direction (1) selon l'une quelconque des revendications précédentes, **caractérisé en ce que** sur le côté intérieur du boîtier de base (5), il existe des points de contact (29, 31, 33) accessibles au niveau du réseau de contact (23) sur les quels passent des frotteurs de contact (37, 39) présentant un pont de contact.
